# EUROPEAN PATENT APPLICATION

(11) **EP 3 627 653 A1**
(43) Date of publication of application: **25.03.2020**
(21) Application number: 19198095.2
(22) Date of filing: 18.09.2019
(51) Int. Cl.: H02J 7/00, H02J 7/02, H02J 50/10

(54) **INDUCTIVE CHARGING DOCK**

(30) Priority: 19.09.2018 US 201862733567 P; 09.09.2019 US 201916564712
(71) Applicant: Apple Inc., Cupertino CA 95014 (US)
(72) Inventor: THOMPSON, Paul J., Cupertino, CA 95014 (US); GRAHAM, Christopher S., Cupertino, CA 95014 (US); Larsson, Karl Ruben Fredrik, Cupertino, CA 95014 (US)
(74) Representative: Barton, Russell Glen

(57) **Abstract**

An inductive charging dock is disclosed that includes a charging dock housing defining an interior volume. The inductive charging dock housing is configured to support a portable electronic device during a wireless charging operation and includes a radio frequency (RF) transparent window. An induction coil is disposed within the interior volume and configured to generate a magnetic flux that exits the charging dock housing through the RF transparent window. A cooling fan is disposed within the interior volume and is configured to establish a flow of cooling air along a path that extends through an air gap between the induction coil and the RF transparent window

## Description

### CROSS REFERENCES TO RELATED APPLICATIONS

This application claims priority to the U.S. Non-Provisional Patent Application No. 16/564,712, filed September 9, 2019, which claims the benefit of the priority in the U.S. Provisional Patent Application 62/733,567, filed September 19, 2018, the contents of which are incorporated by reference in their entirety and for all purposes.

### FIELD

The described embodiments relate generally to an inductive charging dock. More particularly, the present embodiments are directed towards an actively cooled inductive charging dock that allows for fast charging of a portable electronic device.

### BACKGROUND

Wireless charging has become an increasingly popular way to recharge a portable electronic device for many reasons. When the portable electronic device relies entirely upon wireless charging the portable electronic device no longer needs a charging port, which can improve the portable electronic device's resistance to water or particular intrusion. Wireless charging also tends to be easier as a user is no longer required to plug a charging cable into a small plug receptacle on the portable electronic device. Unfortunately, wireless charging tends to be slower than charging performed with a conventional cable. Thus, ways of improving the speed of wireless charging are desirable.

### SUMMARY

This disclosure describes various embodiments that relate to configurations of an inductive charging dock with active cooling that enable the dock to wireless charge an electronic device at an improved charging speed.

An inductive charging dock is disclosed and includes the following: a charging dock housing defining an interior volume and being configured to support a portable electronic device during a charging operation, the charging dock housing comprising a radio frequency (RF) transparent window; an induction coil disposed within the interior volume and spaced apart from the RF transparent window defining an airgap between the induction coil and RF transparent window, the induction coil configured to generate a magnetic flux that exits the charging dock housing through the RF transparent window; and a cooling fan disposed within the interior volume, the cooling fan being configured to establish a flow of cooling air along a path that extends through the air gap and across the induction coil.

Another inductive charging dock is disclosed and includes the following: a charging dock housing, comprising: a base; and a support wall protruding vertically from the base, the base and support wall cooperatively defining an interior volume of the charging dock housing. The inductive charging dock also includes an induction coil disposed within a first portion of the interior volume defined by the support wall; and a cooling fan disposed within the interior volume and being configured to establish a flow of cooling air passing through a second portion of the interior volume defined by the base, the first portion of the interior volume defined by the support wall and then exits through an opening positioned at a distal end of the support wall.

Another inductive charging dock is disclosed and includes the following: a charging dock housing defining an interior volume and being configured to support a portable electronic device during a charging operation; an induction coil disposed within the interior volume and configured to generate a magnetic flux that exits the charging dock housing; and a cooling fan disposed within the interior volume, the cooling fan being configured to establish a flow of cooling air from a second portion of the interior volume defined by the base, through the first portion of the interior volume defined by the support wall and exiting the charging dock housing through an air outlet opening positioned at a distal end of the support wall.

Other aspects and advantages of the invention will become apparent from the following detailed description taken in conjunction with the accompanying drawings which illustrate, by way of example, the principles of the described embodiments.

### BRIEF DESCRIPTION OF THE DRAWINGS

The disclosure will be readily understood by the following detailed description in conjunction with the accompanying drawings, wherein like reference numerals designate like structural elements, and in which:
FIG. 1 is a block diagram illustrating an exemplary portable electronic device, an exemplary power supplying apparatus for coupling with the exemplary portable electronic device to charge the exemplary portable electronic device;
FIG. 2 illustrates an exemplary wireless charging system during wireless power transfer;
FIG. 3A shows an exploded perspective view of an inductive charging stand suitable for wirelessly charging a portable electronic device;
FIG. 3B shows a cross-sectional view of the inductive charging stand depicted in FIG. 3A with the portable electronic device positioned thereon;
FIG. 4A shows an exploded perspective view of an inductive charging stand suitable for wirelessly charging a portable electronic device in at least two different orientations;
FIG. 4B shows how an induction coil of a portable electronic device can be aligned with lower induction coil when the portable electronic device is positioned in a horizontal or landscape orientation;
FIG. 4C shows how the induction coil of portable electronic device 450 can be aligned with upper induction coil 412 when portable electronic device is positioned in a vertical or portrait orientation; and
FIG. 5 shows a flow chart illustrating a method of operating an inductive charging dock.

### DETAILED DESCRIPTION

Representative applications of methods and apparatus according to the present application are described in this section. These examples are being provided solely to add context and aid in the understanding of the described embodiments. It will thus be apparent to one skilled in the art that the described embodiments may be practiced without some or all of these specific details. In other instances, well known process steps have not been described in detail in order to avoid unnecessarily obscuring the described embodiments. Other applications are possible, such that the following examples should not be taken as limiting.

In the following detailed description, references are made to the accompanying drawings, which form a part of the description and in which are shown, by way of illustration, specific embodiments in accordance with the described embodiments. Although these embodiments are described in sufficient detail to enable one skilled in the art to practice the described embodiments, it is understood that these examples are not limiting; such that other embodiments may be used, and changes may be made without departing from the spirit and scope of the described embodiments.

Inductive charging stands provide a convenient way to recharge a portable electronic device but can suffer from extended charging times. One solution to this problem is to incorporate a cooling fan into an inductive charging dock. By configuring cooling fan to circulate air from a base of the inductive charging stand to its top, charging performance can be improved as this active cooling configuration allows a transmitting induction coil within the inductive charging stand to be continuously cooled so that excess heat energy generated by energizing the induction coil does not overheat the inductive charging dock or the portable electronic device being supported by the inductive charging dock. In some embodiments, a flow of air generated by the cooling fan can pass between an air gap between the transmitting induction coil and a radio frequency (RF) transparent window through which the induction coil is configured to project a magnetic flux. The magnetic flux can then induce a current in an induction coil within the portable electronic device being supported by the inductive charging dock.

In some embodiments the inductive charging stand can include two or more spatially offset induction coils that allow a user to place a portable electronic device in multiple different orientations upon the inductive charging dock. For example, a two induction coil configuration could allow the portable electronic device to be charged in both a vertical and horizontal orientation.

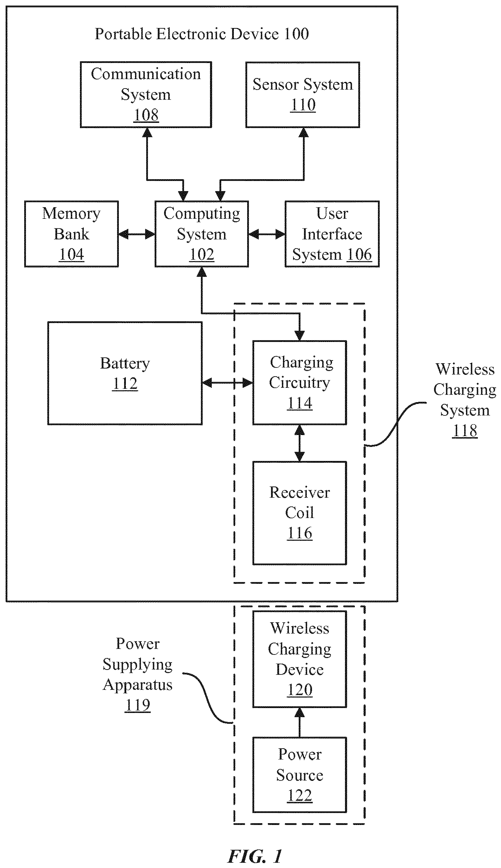

These and other embodiments are discussed below with reference to FIGS. 1 - 5; however, those skilled in the art will readily appreciate that the detailed description given herein with respect to these figures is for explanatory purposes only and should not be construed as limiting.

FIG. 1 is a block diagram illustrating an exemplary portable electronic device 100, an exemplary power supplying apparatus 119 for coupling with device 100 to charge device 100, according to some embodiments of the present disclosure. Device 100 includes a computing system 102 coupled to a memory bank 104. Computing system 102 can include control circuitry configured to execute instructions stored in memory bank 104 for performing a plurality of functions for operating device 100. The control circuitry can include one or more suitable computing devices, such as microprocessors, computer processing units (CPUs), graphics processing units (GPUs), field programmable gate arrays (FPGAs), and the like.

Computing system 102 can also be coupled to a user interface system 106, a communication system 108, and a sensor system 110 for enabling electronic device 100 to perform one or more functions. For instance, user interface system 106 can include a display, speaker, microphone, actuator for enabling haptic feedback, and one or more input devices such as a button, switch, capacitive screen for enabling the display to be touch sensitive, and the like. Communication system 108 can include wireless telecommunication components, Bluetooth components, and/or wireless fidelity (WiFi) components for enabling device 100 to make phone calls, interact with wireless accessories, and access the Internet. Sensor system 110 can include light sensors, accelerometers, gyroscopes, temperature sensors, and any other type of sensor that can measure a parameter of an external entity and/or environment.

Many or even all of these electrical components require a power source to operate. Accordingly, electronic device 100 also includes a battery 112 for discharging stored energy to power the electrical components of device 100. To replenish the energy discharged to power the electrical components, electronic device 100 includes a wireless charging system 118. Wireless charging system 118 can include charging circuitry 114 and receiver/transmitter coil 116 for receiving power from a wireless charging device 120 coupled to an external power source 122. Wireless charging device 120 can include a transmitter coil for generating a time-varying magnetic flux capable of generating a corresponding current in receiver coil 116. The generated current can be utilized by charging circuitry 114 to charge battery 112.

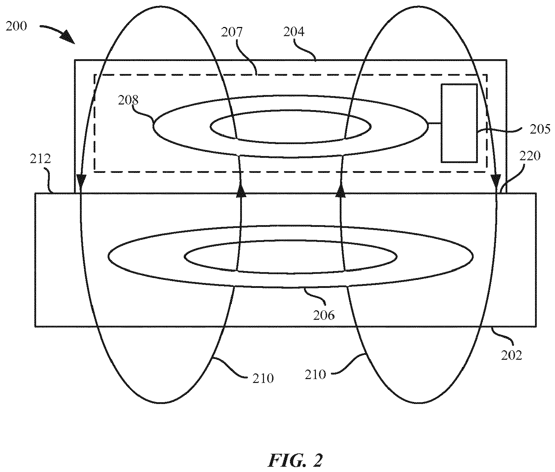

FIG. 2 illustrates an exemplary wireless charging system during wireless power transfer. Specifically, FIG. 2 illustrates the electrical interactions experienced by an exemplary wireless charging system as it is receiving power from a wireless charging device. A portable electronic device 204 is positioned on a charging surface 212 of a wireless charging device 202. Portable electronic device 204 can include a wireless charging system 207 that has a receiver/transmitter coil 208 and charging circuitry 205; and wireless charging device 202 can include a transmitter coil 206. Receiver coil 208 can be an inductor coil that can interact with and/or generate time-varying magnetic flux. Electronic device 204 can be a consumer electronic device, such as a smart phone, tablet, battery case and the like. Wireless charging device 202 can be any suitable device configured to generate time-varying magnetic field or flux to induce a corresponding current in a receiving device. For instance, wireless charging device 202 can be a wireless charging mat, puck, docking station, and the like. Electronic device 204 may rest on the wireless charging device 202 at charging surface 212 to facilitate the wireless transfer of power.

During wireless power transfer from wireless charging device 202 to portable electronic device 204, wireless charging system 207 can operate to receive power from wireless charging device 202. For instance, charging circuitry 205 can operate receiving coil 208 as a receiving coil to receive power by interacting with time-varying magnetic flux 210 generated by transmitter coil 206. Charging circuitry 205 can correspond with charging circuitry 114 in FIG. 1. Interaction with time-varying magnetic flux 210 results in an inducement of current in hybrid receiver/transmitter coil 208, which can be used by charging circuitry 205 to charge an internal battery of portable electronic device 204. As shown in FIG. 2, portable electronic device 204 can rest on charging surface 212 of wireless charging device 202. In some embodiments, an interface surface 220 of portable electronic device 204 makes contact with charging surface 212 during wireless power transfer. Thus, portable electronic device 204 can receive power through interface surface 220. Interface surface 220 can be an external surface of a housing of portable electronic device 204.

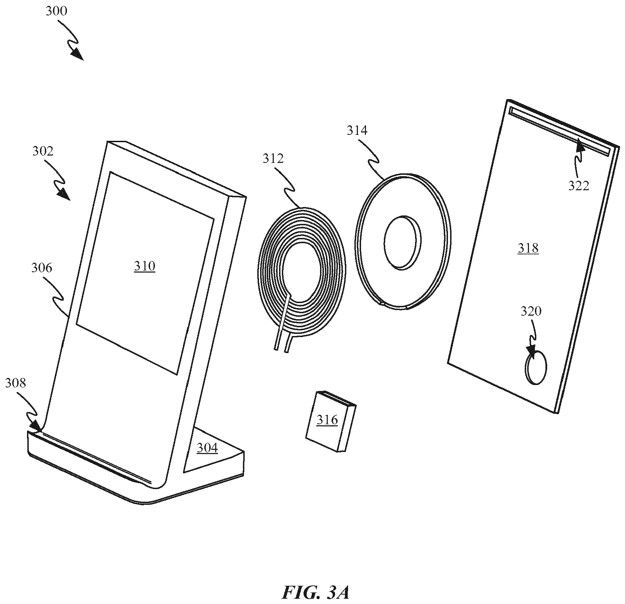

FIG. 3A shows an exploded perspective view of an inductive charging stand 300 suitable for wirelessly charging a portable electronic device. Inductive charging stand 300 includes charging device housing 302. Charging device housing 302 includes a base 304 and an integrally formed support wall 306. In other embodiments, support wall 306 can be removable from base 304 and attached by engaging a slot of or being fastened to base 304. Base 304 can define a concave receiving channel 308 configured to receive a portable electronic device. Support wall 306 can be formed primarily of structurally robust, radio opaque materials such as anodized aluminum or stainless steel. Support wall 306 is configured to provide a surface upon which a portable electronic device can rest and be viewed while the portable electronic device is wirelessly receiving power. A radio transparent window 310 can form a portion of support wall 306 that accommodates the passage of a magnetic flux generated by an induction coil 312. Support structure 314 can defined an annular channel within which induction coil 312 fits. In some embodiments support structure 314 can be formed a ferritic material such as stainless steel, thereby allowing support structure 314 to act as a shunt that helps direct energy from the magnetic flux generated by induction coil 312 out of charging device housing 302 through radio transparent window 310. In some embodiments, induction coil 312 can be a stranded bifilar coil formed from two closely spaced parallel windings.

FIG. 3A also shows a rear cover 318 of support wall 306 that can also be formed from radio opaque materials such as stainless steel or aluminum alloys. Rear cover 314 can be removable to help facilitate the assembly and/or replacement of internal components such as induction coil 312, support structure 314 and a cooling fan 316, which are disposed within support wall 306. Rear cover 318 can include both an air inlet opening 320 and an air outlet opening 322. An air intake of cooling fan 316 can be positioned proximate air inlet opening 318. When cooling fan 316 is a centrifugal fan, cooling air drawn into support wall through air inlet opening 320 can be redirected by 90 degrees to travel vertically within an interior volume defined by support wall 306 and toward air outlet opening 322. The cooling air can be configured to convectively draw heat away from induction coil 312 and other electronics within support wall 306 and then remove the heat from inductive charging stand 300 as the cooling air exits support wall 306 through air outlet opening 322. By actively cooling induction coil 312 higher rates of charging can be achieved. It should be noted that an angle at which inductive charging dock 300 positions a portable electronic device relative to a supporting surface is generally a fixed angle, this fixed angle can vary between about 45 and 75 degrees.

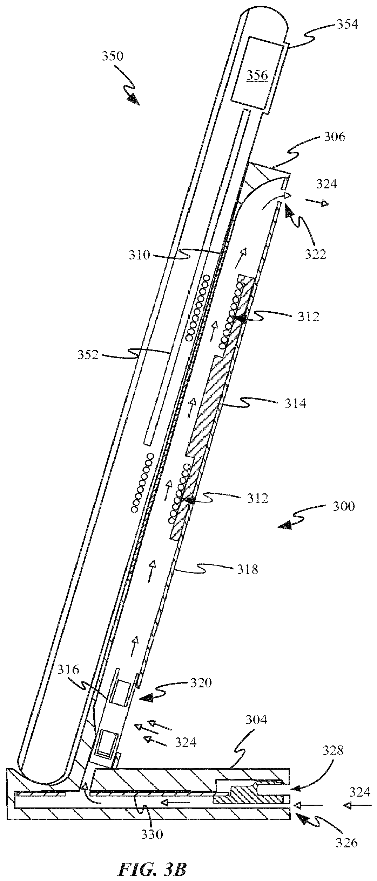

FIG. 3B shows a cross-sectional view of inductive charging stand 300 with portable electronic device 350 positioned thereon. FIG. 3B shows how an outer lip of concave receiving channel 308 helps keep a lower end of portable electronic device 350 from sliding out of concave receiving channel 308. A partial arrangement of components within inductive charging components is depicted in FIG. 3B; however, it should be appreciated that some components were excluded to focus the figure on features directed toward the primary functionality of inductive changing stand 300 as a wireless charging device. Induction coil 312 is placed within structural wall at a height that corresponds to a position of an induction coil within portable electronic device 350. In some embodiments, charging device can be configured to working with multiple different phone models that have a standardized induction coil position configured to correspond to the position of induction coil 312.

FIG. 3B also shows a path of cooling air through charging device housing 302. In particular, cooling fan 316 draws a majority of cooling air 324 into charging device housing 302 through air inlet opening 320. While cooling fan 316 can be turned on to induce cooling air 324 to flow through support wall 306, cooling air 324 also tends to flow vertically through support wall 306 due to it rising as a result of being heated up by electrical components within support wall 306. Induction coil 312 is the primary culprit for heat generation within device 300. Cooling air 324 can be particularly effective at preventing heat generated by induction coil 312 from heating up electronic device 300 since cooling air 324 flows through an air gap between induction coil 312 and radio transparent window 310 of support wall 306. In this way, cooling air 324 is able to absorb heat energy from radio transparent window 310, induction coil 312 and support structure 314. In some embodiments, radio transparent window 310 can be formed from a thermally conductive material such as silicon carbide, silicon nitride or a glass ceramic material that allows accumulated heat to be evenly distributed for efficient dissipation of heat from radio transparent window 310. Cooling air 324 can also be drawn through base 304 through auxiliary air inlet 326. Cooling air 324 drawn through auxiliary inlet 326 can help to dissipate heat generated by input/output receptacle 328 and printed circuit board 330. In some embodiments, the input/output receptacle 328 can be configured to receive standardized plugs such as micro-USB or Lightning connector plugs.

In some embodiments, cooling fan 316 can be configured to continue operating continuously or intermittently after a charging operation is completed. This feature can be desirable when portable electronic device 350 is generating heat due to the portable electronic device 350 being utilized for high processing power applications such as games or media manipulation operations. This form of heat dissipation can be particularly effective given the proximity of main logic board 352 to radio transparent window 310. In some embodiments, a temperature sensor can be incorporated within support wall 306 and/or base 304 to cue when and at what speed cooling fan 316 should operate. It should be noted that a height of support wall 306 can be set so that camera protrusion 354 associated with camera module 356 does not interfere with portable electronic device 350 lying flat against support wall 306.

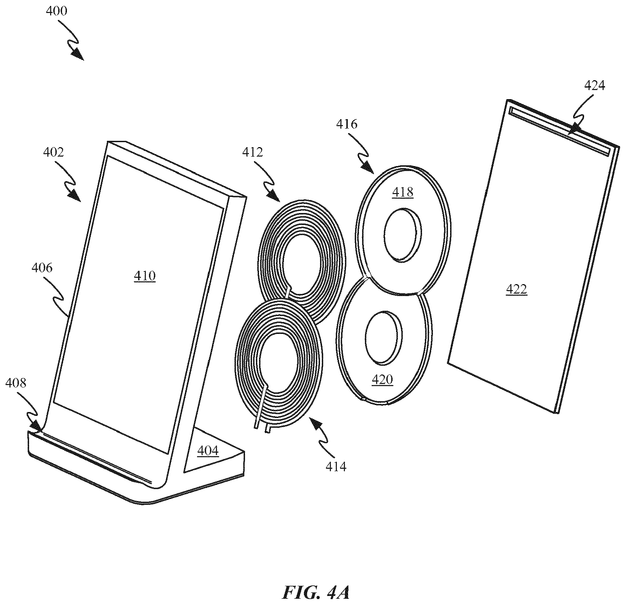

FIG. 4A shows an exploded perspective view of an inductive charging stand 400 suitable for wirelessly charging a portable electronic device in at least two different orientations. Inductive charging stand 400 includes charging device housing 402. Charging device housing 402 includes a base 404 and an integrally formed support wall 406. Base 404 can define a concave receiving channel 408 configured to receive a portable electronic device. Support wall 306 can be formed primarily of structurally robust, radio opaque materials such as aluminum or stainless steel. Support wall 406 is configured to provide a surface upon which a portable electronic device can rest and be viewed while the portable electronic device is wirelessly receiving power. A radio transparent window 410 can form a portion of support wall 406 that accommodates the passage of magnetic fields generated by induction coils 412 and 414. Support structure 416 can define two adjacent annular channels 418 and 420 within which induction coils 412 and 414 fit. In some embodiments, support structure 416 can be formed from stainless steel, thereby allowing support structure 416 to act as a shunt that helps direct energy from magnetic fields emitted by induction coils 412 and 414 out of charging device housing 402 through radio transparent window 410. Annular channel 418 is recessed below annular channel 420 allowing a portion of induction coil 412 to be secured directly below at least a portion of induction coil 414.

FIG. 4A also shows a rear cover 422 of support wall 406 that can also be formed from radio opaque materials such as stainless steel or aluminum alloys. Rear cover 420 can be removable to help facilitate the assembly and/or replacement of internal components such as induction coils 412 and 414 and a support structure 416, which are disposed within support wall 406. Rear cover 422 can include an air outlet opening 424. Air outlet opening 424 can be configured to exhaust cooling air drawn into charging device housing 402 by a cooling fan through an air intake defined by base 404. The cooling air can be configured to convectively dissipate heat generated by induction coil 412 and other electronics within support wall 306 and then remove the dissipated heat from inductive charging stand 400 as the cooling air exits support wall 406 through air outlet opening 424. It should be noted that in some embodiments, rear cover 422 can be integrally formed with side the rest of support wall 406. In this type of configuration, radio frequency transparent window 410 can be removable allowing for the assembly of electrical components within support wall 406.

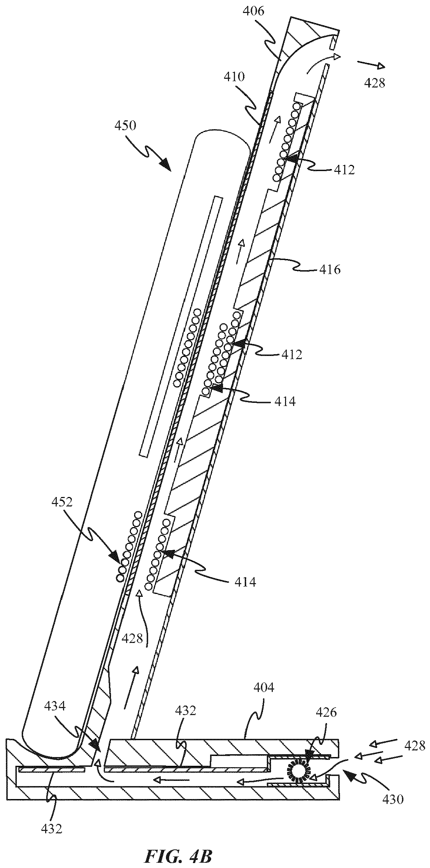

FIGS. 4B - 4C show cross-sectional views of inductive charging stand 400 having a cooling fan 426 that can take the form of a cross-flow fan. Cooling fan 426 can be configured to draw cooling air 428 into a base of inductive charging stand 400 and then upward through an interior volume defined by support wall. Cooling fan 426 can be positioned within a rear region of base 404 proximate rear-facing air inlet opening 430; however, cooling fan 428 could also take the form of a centrifugal fan drawing cooling air 428 through an air inlet opening extending through an upward facing surface of base 404. Cooling air 428 can transition into support wall 406 after flowing along a printed circuit board 432 through an air passage 434. An entry into air passage 434 can be through an opening defined by printed circuit board 432, as depicted. After cooling air 428 transitions into support wall 406, cooling air 428 flows vertically across lower and upper induction coils 414 and 412. Ultimately, after being heated by the convective transfer of heat to cooling air 428, cooling air 428 exits support wall 406 through air outlet opening 424. While specific locations of cooling fan 426 have been pointed out, it should be appreciated that cooling fan 426 could be positioned anywhere along a path taking by cooling air 428 as it flows through base 404 and support wall 406. Cooling fan 426 could also be positioned within support wall 406, similar to cooling fan 316, as depicted in FIG. 3B.

FIG. 4B shows how an induction coil 452 of portable electronic device 450 can be aligned with lower induction coil 414 when portable electronic device 450 is positioned in a horizontal or landscape orientation. With portable electronic device 450 positioned in this orientation, charging dock 400 would only route power to induction coil 414 once an orientation of portable electronic device 450 is determined. In some embodiments, the orientation determination could be performed by induction coils 412 and 414 periodically generating magnetic pulses. Once a magnetic pulse is received by a receiving coil an active charging operation could be commenced by the induction coil that emitted the received magnetic pulse. In this way, only the induction coil that is aligned with the receiving coil needs to be activated. In this way, excess energy and heat output can be avoided.

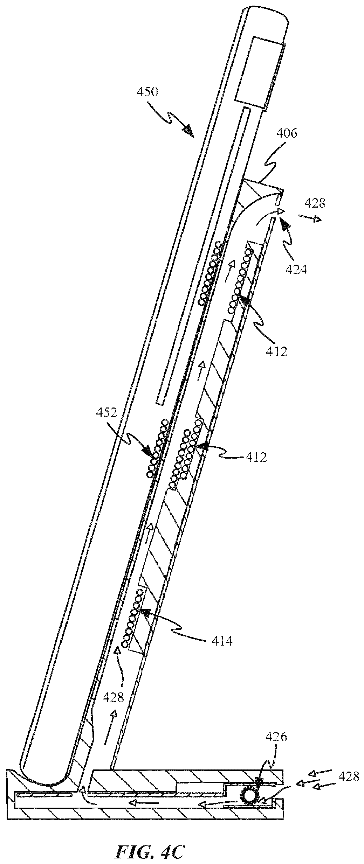

FIG. 4C shows how induction coil 452 of portable electronic device 450 can be aligned with upper induction coil 412 when portable electronic device 450 is positioned in a portrait orientation. As described previously, only upper induction coil 412 would be activated given this orientation of portable electronic device 450. Other means of orientation detection could take the form of a strain gauge configured to measure an amount of torque applied at the intersection of support wall 406 and base 404. A portrait orientation could be assumed to generate a greater amount of strain at the intersection between support wall 406 and base 404 than a landscape orientation allowing the strain gauge to distinguish a portrait vs a landscape orientation by way of the amount of strain detected.

It should be noted that while cooling air 428 is depicted flowing between RF transparent window 410 and induction coils 412 and 414, induction coils 412 and 414 could also be affixed or adjacent to a rear-facing surface of RF transparent window 410 in order to increase an efficiency of the inductive coupling between induction coils 414 and 452. In a configuration wherein induction coil 414 is adjacent to RF transparent window 410 cooling air 428 could instead be routed along a backside of support structure 416. In this way, any heat being conducted to support structure 416 by induction coils 412 and 414 could be convectively dissipated by cooling air 428. In some embodiments, the backside of support structure 416 can include cooling fins to assist in the dissipation of heat built up within support structure 416.

It should also be noted that in some embodiments, charging dock 400 can include a support wall that is configured to support an electronic device in a substantially horizontal orientation. For example, the substantially horizontal orientation could be between 0 and 10 degrees relative to a surface upon which charging dock 400 is being supported. In such a configuration support wall could house three or more overlapping induction coils that allow portable electronic device 450 to be placed in a wider variety of positions and orientations.

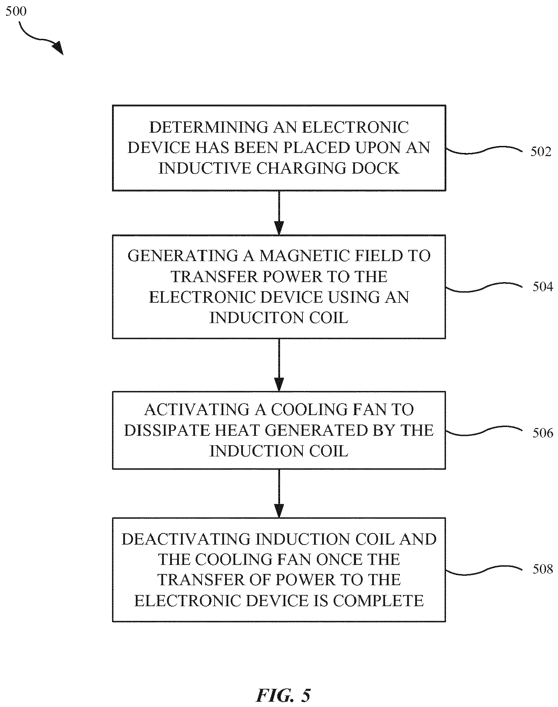

FIG. 5 shows a flow chart illustrating a method of operating an inductive charging dock. At 502, a charging dock can be configured to detect a presence and or orientation of an electronic device placed upon the charging dock. In some embodiments, presence detection can be carried out by a weight sensor. For example, when the weight sensor detects an increased amount of force from a portion of the charging dock configured to support a portable electronic device, induction coils of the charging dock can be energized to attempt initiation of a charging operation. At 504, the charging operation can be initiated when one of the receiving coils of the portable electronic device are aligned with a transmitting coil of the charging dock. In some use cases, misalignment of the induction coils can result in termination of the power transfer.

FIG. 5 also shows how at 506, a cooling fan can be activated to dissipate heat generated by the wireless transfer of power. The cooling fan directs cooling air so that it flows between the transmitting induction coil of the charging device and a radio frequency (RF) transparent window of the inductive charging dock. In some embodiments, the cooling fan can be configured to draw air through both a base and support wall of the inductive charging dock so that circuit boards and other heat emitting components distributed throughout the device can be cooled, thereby allowing the inductive charging dock to operate at peak efficiency. Depending on user preference, charging dock can also be configured to continue operating its cooling fan in order to dissipate heat generated by the portable electronic device itself. Such a configuration may be beneficial when the portable electronic device is performing processor or graphics processing unit intensive tasks that tend to generate substantial amounts of heat. At 508, the induction coil and cooling fan can be deactivated once a transfer of energy is complete. In some use cases, the deactivation could be in response to the portable electronic device being removed from the charging device prior to a charging operation being complete. In some use cases, deactivation of the cooling fan can be tied to a temperature sensor within the charging dock instead of being tied specifically to a commencement and termination of a charging operation. In this way, the cooling fan only need be active during periods in which excess heat is removed to optimize charging dock performance. In some embodiments, this can be particularly helpful when inductive charging device is battery powered.

The various aspects, embodiments, implementations or features of the described embodiments can be used separately or in any combination. Various aspects of the described embodiments can be implemented by software, hardware or a combination of hardware and software. The described embodiments can also be embodied as computer readable code on a computer readable medium for controlling manufacturing operations or as computer readable code on a computer readable medium for controlling a manufacturing line. The computer readable medium is any data storage device that can store data, which can thereafter be read by a computer system. Examples of the computer readable medium include read-only memory, random-access memory, CD-ROMs, HDDs, DVDs, magnetic tape, and optical data storage devices. The computer readable medium can also be distributed over network-coupled computer systems so that the computer readable code is stored and executed in a distributed fashion.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of specific embodiments are presented for purposes of illustration and description. They are not intended to be exhaustive or to limit the described embodiments to the precise forms disclosed. It will be apparent to one of ordinary skill in the art that many modifications and variations are possible in view of the above teachings.

Numbered aspects of the Invention :
1. An inductive charging dock, comprising:
   a charging dock housing defining an interior volume and being configured to support a portable electronic device during a wireless charging operation, the charging dock housing comprising a radio frequency (RF) transparent window;
   an induction coil disposed within the interior volume and spaced apart from the RF transparent window defining an airgap between the induction coil and RF transparent window, the induction coil configured to generate a magnetic flux that exits the charging dock housing through the RF transparent window; and
   a cooling fan disposed within the interior volume, the cooling fan being configured to establish a flow of cooling air along a path that extends through the air gap and across the induction coil.
2. The inductive charging dock as recited in 1, wherein the charging dock housing comprises a base and a support wall, and wherein the cooling fan and the induction coil are disposed within the support wall.
3. The inductive charging dock as recited in 1, wherein the induction coil is a first induction coil and the inductive charging dock further comprises a second induction coil.
4. The inductive charging dock as recited in 3, wherein a first portion of the first induction coil overlaps a second portion of the second induction coil.
5. The inductive charging dock as recited in 1, wherein the charging dock housing comprises a base and a support wall, and wherein the cooling fan circulates cooling air through the base and the support wall.
6. The inductive charging dock as recited in 5, wherein the cooling fan draws air into the support wall through an air inlet opening defined by an exterior surface of the support wall facing away from a region of the inductive charging dock configured to support the portable electronic device.
7. The inductive charging dock as recited in 6, wherein an air outlet opening is also defined by the exterior surface of the support wall facing away from the region of the inductive charging dock configured to support the portable electronic device.
8. The inductive charging dock as recited in 1, wherein the cooling fan is a centrifugal fan.
9. The inductive charging dock as recited in 1, wherein the charging dock housing comprises a support wall and a base that defines a concave recess adjacent to the support wall.
10. An inductive charging dock, comprising:
   a charging dock housing, comprising:
      a base; and
      a support wall protruding away from the base, the base and support wall cooperatively defining an interior volume of the charging dock housing;
   an induction coil disposed within a first portion of the interior volume defined by the support wall; and
   a cooling fan disposed within the interior volume and configured to establish a flow of cooling air from a second portion of the interior volume defined by the base, through the first portion of the interior volume defined by the support wall and exiting the charging dock housing through an air outlet opening positioned at a distal end of the support wall.
11. The inductive charging dock as recited in 10, wherein the support wall further comprises a rear cover defining both an air inlet opening and the air outlet opening.
12. The inductive charging dock as recited in 10, wherein the cooling fan is disposed within the second portion of the interior volume defined by the base.
13. The inductive charging dock as recited in 10, wherein the base defines a concave channel at an intersection between the base and the support wall.
14. The inductive charging dock as recited in 10, wherein the cooling fan is disposed within the first portion of the interior volume defined by the support wall.
15. The inductive charging dock as recited in 10, further comprising a printed circuit board disposed within the second portion of the interior volume.
16. The inductive charging dock as recited in 15, wherein the printed circuit board defines an opening and wherein the flow of cooling air passes through the opening defined by the printed circuit board.
17. An inductive charging dock, comprising:
   a charging dock housing defining an interior volume and being configured to support a portable electronic device during a charging operation;
   an induction coil disposed within the interior volume and configured to generate a magnetic flux that exits the charging dock housing; and
   a cooling fan disposed within the interior volume, the cooling fan being configured to establish a flow of cooling air along a path that extends through an air gap between the induction coil and a surface of the charging dock housing that is configured to contact the portable electronic device.
18. The inductive charging dock as recited in 17, wherein the charging dock housing comprises a base and a support wall and wherein the induction coil is disposed within the support wall.
19. The inductive charging dock as recited in 18, wherein the charging dock is configured to orient the portable electronic device at an angle of between 45 and 75 degrees relative to a support surface upon which the charging dock housing rests.
20. The inductive charging dock as recited in 17, wherein a material forming the charging dock housing is selected from the group consisting of anodized aluminum and stainless steel.

## Claims

1. An inductive charging dock, comprising:
a charging dock housing defining an interior volume and being configured to support a portable electronic device during a wireless charging operation, the charging dock housing comprising a radio frequency (RF) transparent window;
an induction coil disposed within the interior volume and spaced apart from the RF transparent window defining an airgap between the induction coil and RF transparent window, the induction coil configured to generate a magnetic flux that exits the charging dock housing through the RF transparent window; and
a cooling fan disposed within the interior volume, the cooling fan being configured to establish a flow of cooling air along a path that extends through the air gap and across the induction coil.

2. The inductive charging dock as recited in claim 1, wherein the charging dock housing comprises a base and a support wall, and wherein the cooling fan and the induction coil are disposed within the support wall.

3. The inductive charging dock as recited in any preceding claim, wherein the induction coil is a first induction coil and the inductive charging dock further comprises a second induction coil.

4. The inductive charging dock as recited in claim 3, wherein a first portion of the first induction coil overlaps a second portion of the second induction coil.

5. The inductive charging dock as recited in any preceding claim, wherein the charging dock housing comprises a base and a support wall, and wherein the cooling fan circulates cooling air through the base and the support wall.

6. The inductive charging dock as recited in claim 5, wherein the cooling fan draws air into the support wall through an air inlet opening defined by an exterior surface of the support wall facing away from a region of the inductive charging dock configured to support the portable electronic device.

7. The inductive charging dock as recited in claim 6, wherein an air outlet opening is also defined by the exterior surface of the support wall facing away from the region of the inductive charging dock configured to support the portable electronic device.

8. The inductive charging dock as recited in any preceding claim, wherein the cooling fan is a centrifugal fan.

9. The inductive charging dock as recited in any preceding claim, wherein the charging dock housing comprises a support wall and a base that defines a concave recess adjacent to the support wall.

10. The inductive charging dock as recited in any preceding claim, wherein the charging dock housing comprises a base and a support wall protruding away from the base, the base and support wall cooperatively defining the interior volume of the charging dock housing.

11. The inductive charging dock as recited in claim 10, wherein the support wall further comprises a rear cover defining both an air inlet opening and the air outlet opening.

12. The inductive charging dock as recited in claim 10 or 11, wherein the base defines a concave channel at an intersection between the base and the support wall.

13. The inductive charging dock as recited in claim 10, 11 or 12, wherein the induction coil is disposed within a first portion of the interior volume defined by the support wall, and the cooling fan is further configured to establish the flow of cooling air from a second portion of the interior volume defined by the base, through the first portion of the interior volume defined by the support wall and exiting the charging dock housing through an air outlet opening positioned at a distal end of the support wall.

14. The inductive charging dock as recited in claim 13, wherein the cooling fan is disposed within the second portion of the interior volume defined by the base.

15. The inductive charging dock as recited in claim 13, wherein the cooling fan is disposed within the first portion of the interior volume defined by the support wall.
